# EUROPEAN PATENT APPLICATION

(11) **EP 1 047 217 A2**
(43) Date of publication of application: **25.10.2000**
(21) Application number: 00303299.2
(22) Date of filing: 19.04.2000
(51) Int. Cl.: H04L 1/00

(54) **Method and system for receiving and decoding digital signals**

(30) Priority: 20.04.1999 GB 9908863
(71) Applicant: Tandberg Television ASA, 1326 Lysaker (NO)
(72) Inventor: Markarian, Garik, Chilworth, Hampshire SO16 7HN (GB); Huggett, Anthony, Eastleigh, Hampshire SP50 5PZ (GB)
(74) Representative: Sturt, Clifford Mark

(57) **Abstract**

The invention relates to receiving and decoding digitally modulated signals that may be coded in either of two different transmission formats. One of the formats may employ convolutional encoding and the other format may employ turbo codes. The invention is particularly applicable to receiving digital television signals.

After demodulation of the modulated signals, first and second decoding paths (32,33:34,35) are employed to digitally decode the demodulated signals. The decoding paths decode according to the two different transmission formats respectively. The success rates of decoding through the first and second decoding paths are determined and the decoding path which provides the higher success rate is selected.

The decoder paths can automatically switch to decode signals that may be transmitted in either of two different formats. No additional information such as preamble sequences or a helper signal need be transmitted and consequently no additional bandwidth is required.

## Description

The present invention relates to receiving and decoding digitally modulated signals which may be in either of two different transmission formats.

In the field of digital television signal transmission, it is common practice to employ convolutional encoding techniques to encode the digital information at the transmitter. The encoded digital signal is passed to a modulator in which a carrier is modulated to represent the digital information. The modulated carrier is transmitted to a receiver equipped with an appropriate demodulator and decoder. The conventional receiver has a Viterbi decoder to decode a convolutionally encoded signal.

More recently introduced "turbo-codes" are expected to become a dominant technique for the encoding of digital television signals, including high definition television (HDTV) signals and return interactive TV signals. Given the large number of receivers already existing that are equipped to receive signals conforming to convolutional coding schemes, the introduction of turbo-code schemes for the encoding of digital television transmissions will require a transition period during which both turbo-codes and convolutional codes will be used. The choice will be made by the transmission provider. Ideally, the transmission provider would be able to choose between a transmission format employing convolutional codes and a transmission format employing turbo-codes. The receiver would desirably respond to decode the transmission in either of the chosen formats. The choice of transmission format (whether employing convolutional encoding or turbo-encoding) would desirably be made by the broadcaster according to the expected broadcast channel conditions and both the power and bandwidth requirements in the transmission media. Preferably the choice would be made without the need to consult the receiver.

A possible solution to this problem would be to transmit preamble sequences to specify the transmission format and switch receivers to receive and decode according to the format specified in the preamble sequences. However, it is difficult to envisage how such preamble sequences could be satisfactorily decoded by a decoder which could decode either convolutional codes or turbo-codes. Another possible solution would be to incorporate information regarding the transmission format into a helper channel. Either solution would require a wider transmission bandwidth and as a result would undesirably reduce the overall system performance and throughput.

It is an aim of the present invention to provide for receiving and decoding digitally modulated signals which may be in either of two different transmission formats.

According to the present invention, there is provided a method of receiving and decoding digitally modulated signals that may be coded in either of two different transmission formats, the method comprising the steps of: demodulating the modulated signals; employing first and second decoding paths to digitally decode the demodulated signals according to a first of the transmission formats and a second of the transmission formats respectively; determining which of the first and second decoding paths is operative to decode the demodulated signals; and, selecting the decoding path which is operative.

Further according to the present invention, there is provided a receiver to receive and decode digitally modulated signals which may be in either of two different transmission formats, the receiver comprising: demodulator means to demodulate the modulated signals; first and second decoding paths including first and second decoders to decode the demodulated signals from the demodulating means according to a first of the transmission formats and a second of the transmission formats respectively; a mode decision logic to determine which of the first and second decoders is operative to decode the demodulated signals; and, a selector to select the decoding path which is operative.

The invention will now be further described, by way of example, with reference to the accompanying drawings in which:
Figure 1 shows a transmission system for transmitting digitally modulated signals which may be in either of two different transmission formats;
Figure 2 shows a modified form of the transmission system of Figure 1;
Figure 3 shows a receiver, according to the present invention, to receive digitally modulated signals from the transmitter of Figure 1;
Figure 4 shows a modified form of the receiver of Figure 3; and,
Figure 5 shows a mode decision logic circuit included in the receiver of Figure 3.

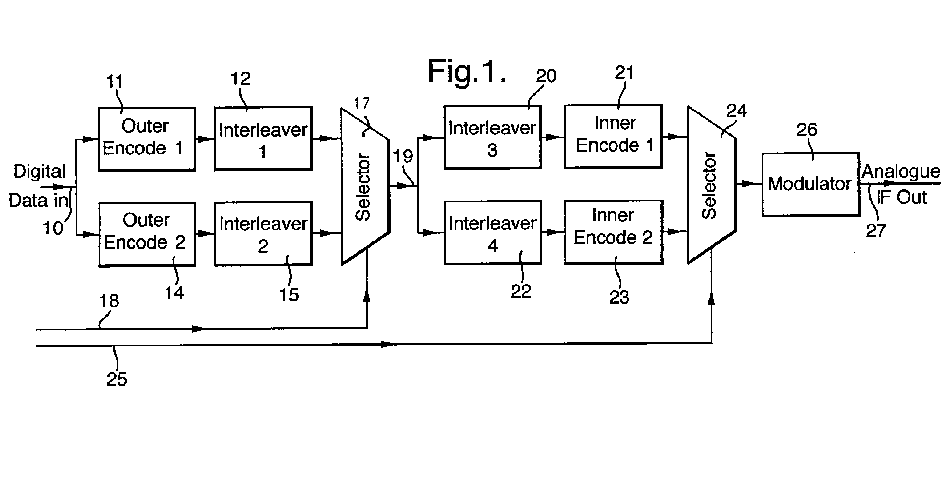

The transmission system of Figure 1 includes an input terminal 10 to receive input digital data representing a digital television signal. The input terminal 10 supplies the input digital data to two parallel outer forward error correction coding chains or paths. The first chain includes an outer block encoder 11 and an interleaver 12. The outer block encoder 11 may be a known form of Reed-Solomon or other conventional block code encoder. The second chain includes an outer block encoder 14, which may be of the same configuration as the block encoder 11 and an interleaver 15.

The encoded digital data from the interleaver 12 and the interleaver 15 is supplied to a first selector 17. The selector 17 also receives a mode select signal on an input line 18. The selector 17 responds to the mode select signal to select which encoded digital data is passed to a selector output line 19. The output line 19 is connected to two parallel inner coding chains or paths. The first inner chain includes an interleaver 20 and an inner encoder 21. The second inner chain includes an interleaver 22 and an inner encoder 23. The encoded digital data from the inner encoder 21 and the inner encoder 23 is passed to a second selector 24. The second selector 24 responds to a mode select signal on an input line 25 to select which encoded digital data is passed to a modulator 26. The inner encoder 21 is a convolutional encoder and the inner encoder 23 is a turbo-encoder. The input to the modulator 26 may therefore be selected to be encoded according to either a convolutional encoding scheme or a turbo-encoding scheme according to the mode selected on the input line 25 connected to the selector 24. The modulator 26 is operative to digitally modulate an analogue intermediate frequency (IF) signal which is output from an output terminal 27.

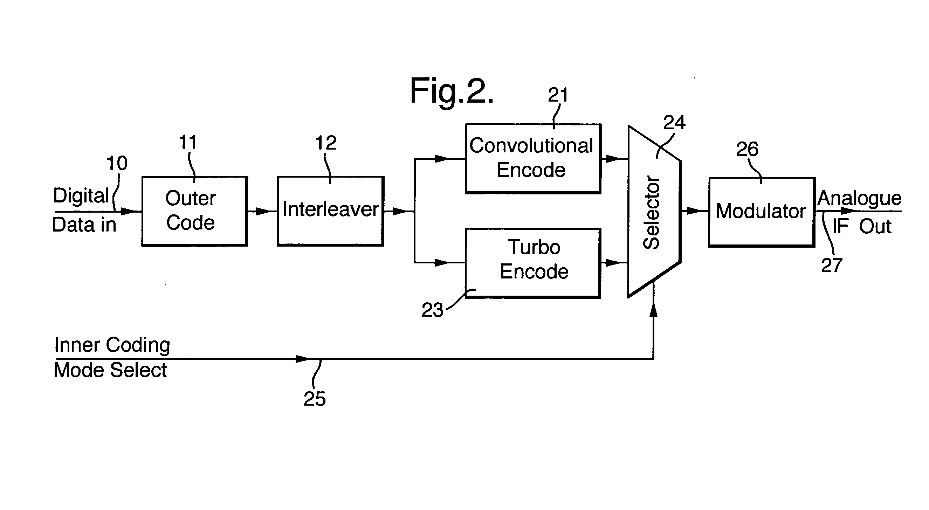

Where elements of the two encoding chains or paths are identical, they may be combined as shown in Figure 2. Thus in Figure 2, the input terminal 10 is connected to a path including the outer block encoder 11 and the interleaver 12. The output of the interleaver 12 is passed to the convolutional encoder 21 and the turbo encoder 23 in parallel. The selector 24 operates to select an output from one of the encoders 21 and 23, according to the input on the line 25. The selection made by the selector 24 is passed to the modulator 26 as before. It will be seen that the outer block encoder 14 and the interleaver 15 have been dispensed with in the arrangement of Figure 2. Other structures are possible if the outer block encoders 11 and 14 only are identical, or if the interleavers 12 and 15 are identical but the encoders 11 and 14 are not. In this final case an additional selector may be placed after the outer block encoders 11 and 14 in order to select which outer code is to be passed to the interleaver.

The choice of transmission format (whether employing convolutional encoding or turbo-encoding) is made by the broadcaster according to the expected channel conditions and both power and bandwidth requirements in the transmission media. In many applications the choice would be made without consulting the receiver.

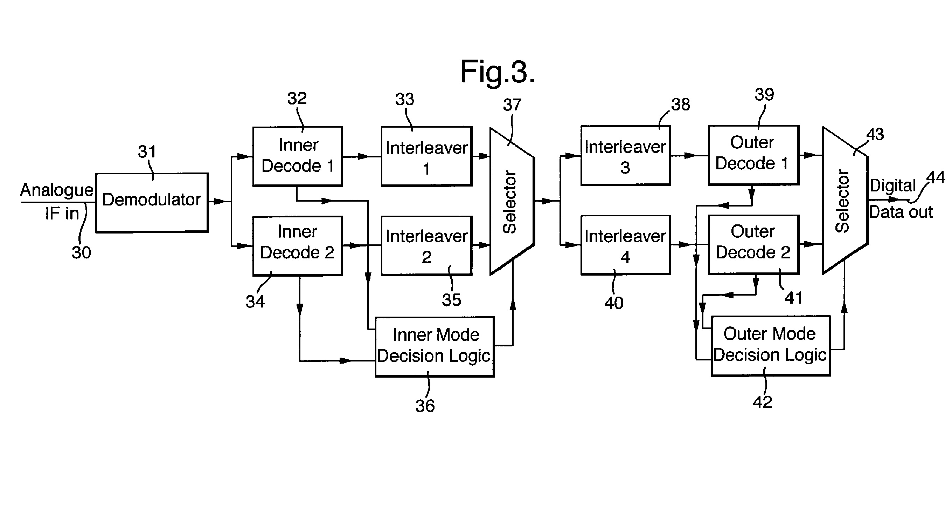

In Figure 3, a receiver has an input terminal 30 to receive the modulated signal transmitted by the transmission system of either Figure 1 or Figure 2. The received signal is passed to a demodulator 31 that demodulates the input signal and passes the demodulated signal to two inner decoding paths in parallel. The first inner decoding path includes a turbo decoder 32 and an interleaver 33. The second inner decoding path includes a Viterbi decoder 34 and an interleaver 35. A mode decision block 36 receives, from the decoders 32 and 34, signals indicative of the success rates in decoding the demodulated signal from the demodulator 31. The mode decision block 36 provides a mode decision signal to a selector 37 which selects the decoded output from either the decoder 32 or the decoder 34. The selection made by the selector 37 is passed to a pair of outer decoding paths.

The first outer decoding path includes an interleaver 38 and an outer decoder 39, and the second outer decoding path includes an interleaver 40 and an outer decoder 41. A mode decision block receives, from the decoders 39 and 41, signals indicative of the success rates in decoding the signals in the respective parallel decoding paths. The mode decision block 42 provides a mode decision signal to a selector 43 which selects the decoded output from either the outer decoder 39 or the outer decoder 41. The selection made by the selector 43 is passed to an output terminal 44.

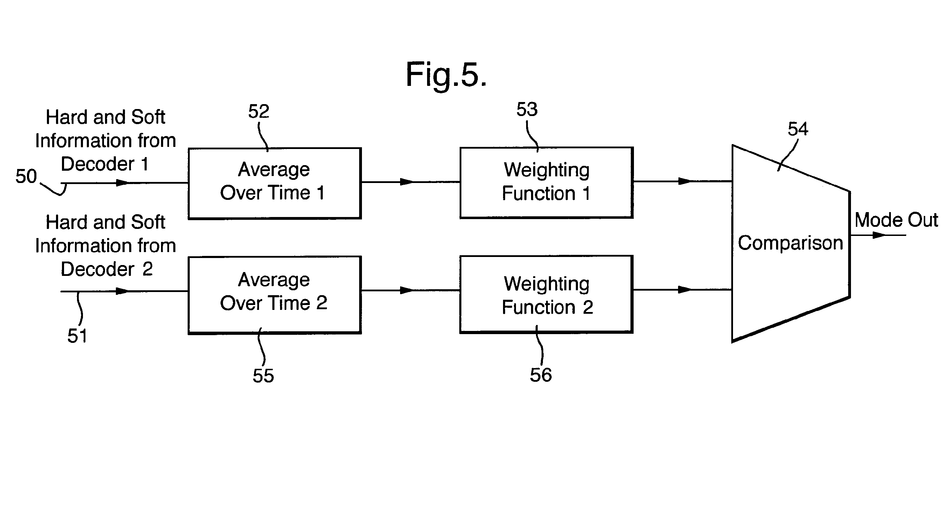

Figure 5 shows the mode decision logic incorporated in the logic block 36 or the logic block 42 of Figure 3. A first input terminal 50 receives hard and soft information from a decoder in the first decoding path and a second input terminal 51 receives hard and soft information form a decoder in the second decoding path. In the case where the mode decision logic of Figure 5 is employed as the logic block 36, the terminal 50 is connected to the inner decoder 32 and the terminal 51 is connected to the inner decoder 34. In the case where the mode decision logic of Figure 5 is employed as the logic block 42, the terminal 50 is connected to the outer decoder 39 and the terminal 51 is connected to the outer decoder 41.

The decoders 32, 34, 39 and 41 are constituted by known integrated circuits which can provide information about the functioning of the circuits. This information includes hard information where a binary signal indicates whether the integrated circuit is working correctly. In the case of Viterbi and Turbo decoders the signal indicates whether there is correct synchronisation of the circuit. In the case of a block code decoder, the signal indicates a failure of the block code to decode; that is to say there are more errors than the code has power to correct. This failure is extremely likely if the transmitted code is not the code that the decoder expects.

The decoders 32, 34, 39 and 41 also provide soft information in the form of a digital value indicating the performance of the channel. The performance represents an estimate of either a Bit Error Ratio (BER) or an estimate of the channel signal to noise ratio expressed in Energy per bit/Noise Power (Eb/No).

The input terminal 50 is connected to a path including an averaging block 52, a weighting module 53 and a first input to a comparator 54. The input terminal 51 is connected to a path including an averaging block 55, a weighting module 56 and a second input to the comparator 54. The averaging blocks 52 and 55 average the hard and soft information provided to the input terminals 50 and 51 over time in order to make a safer decision. This is to allow for the case where the information is not constant even under constant channel conditions. Note that by time averaging the hard information we soften it - the proportion of time for which a decoder is working properly is a soft value.

The weighting modules 53 and 56 weight the time averaged information from the averaging blocks 52 and 55 so as to bias the logic in favour of one piece of channel information or another.

The comparator 54 determines the mode selection and makes a change in mode selection when the input from one channel goes below one predetermined threshold whilst the input from the other channel exceeds another predetermined threshold. A change in mode due to random effects in the channels is avoided by a suitable positioning of the thresholds at which the mode is changed.

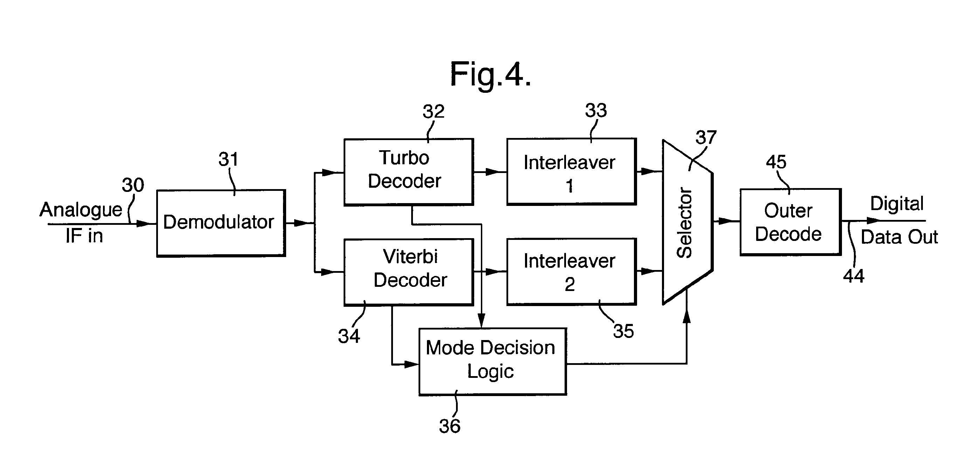

Where the structure of the outer decoders 39 and 41 and the information from the outer decoders is the same, the receiver may be simplified as shown in Figure 4. The outer decoders 39 and 41 are replaced in Figure 4 by a single outer decoder 45 which is disposed between the selector 37 and the output terminal 44.

What has been described is a receiver in which the decoders can automatically switch to decode signals that may be transmitted in either of two different formats. No additional information such as preamble sequences or a helper signal need be transmitted and consequently no additional bandwidth is required.

The invention has been described in relation to the reception and decoding of digitally modulated signals and coded in either a transmission format employing turbo-codes or a transmission format employing convolutional codes. It will be apparent that the invention is applicable to the reception and decoding of digitally modulated signals coded in transmission formats employing codes other than convolutional or turbo-codes providing the success rates in the decoding paths can be used to determine which transmission format is being broadcast. An example of such an alternative code is a block code.

This invention is relevant to the new DVB - RCS Standard (Interactive Return Satellite Channel) which will include turbo-codes as an option to the convolutional codes. Thus, DVB - RCS terminals may operate in two different modes, turbo and convolutional. The corresponding receivers may also have similar modes.

## Claims

1. A method of receiving and decoding digitally modulated signals that may be coded in either of two different transmission formats, the method comprising demodulating the modulated signals, and being characterised by:
employing first and second decoding paths (32,33:34,35) to digitally decode the demodulated signals according to a first of the transmission formats and a second of the transmission formats respectively;
determining which of the first and second decoding paths is operative to decode the demodulated signals; and
selecting the decoding path which is operative.

2. A method as claimed in claim 1, further characterised in that the step of employing first and second decoding paths (32,33:34,35) to digitally decode the demodulated signals according to a first of the transmission formats and a second of the transmission formats respectively, comprises decoding the demodulated signals in the first decoding path (32, 33) according to a transmission format employing turbo-codes and decoding the demodulated signals in the second decoding path (34, 35) according to a transmission format employing convolutional codes.

3. A method as claimed in claim 1 or 2, further characterised in that the step of determining which of the first and second paths is operative to decode the demodulated signals comprises determining if there is correct synchronisation in the first and second decoding paths.

4. A method as claimed in claim 1 or 2, further characterised in that the step of determining which of the first and second decoding paths is operative to decode the demodulated signals comprises forming an estimate of the performance of the first and second decoding paths.

5. A method as claimed in any one of the preceding claims, further characterised in that the method is applied to receiving and decoding digitally modulated signals that are digital television signals.

6. A receiver to receive and decode digitally modulated signals which may be in either of two different transmission formats, the receiver having demodulator means (31) to demodulate the modulated signals and being characterised by:
first and second decoding paths 32,33:34,35) including first and second decoders (32, 34) to decode the demodulated signals from the demodulating means (31) according to a first of the transmission formats and a second of the transmission formats respectively;
a mode decision logic (36) to determine which of the first and second decoders (32, 34) is operative to decode the demodulated signals; and
a selector (37) to select the decoding path which is operative.

7. A receiver as claimed in claim 6, further characterised in that the first decoding path has a decoder (32) for decoding the demodulated signals according to a transmission format employing turbo-codes and the second decoding path has a decoder (34) for decoding the demodulated signals according to a transmission format employing convolutional codes.

8. A receiver as claimed in claim 6 or 7, further characterised in that the mode decision logic (36) determines which of the first and second decoding paths is operative to decode the demodulated signals by determining if there is correct synchronisation in the first and second decoding paths.

9. A receiver as claimed in claim 6 or 7, further characterised in that the mode decision logic (36) determines which of the first and second decoding paths is operable to decode the demodulated signals by forming an estimate of the performance of the first and second decoding paths.

10. A receiver as claimed in any one of claims 6 to 9, further characterised by being adapted to receive and decode digitally modulated signals in the form of digital television signals.

11. A method of transmitting digital information characterised by the steps of encoding the digital information according to both a first transmission format and a second transmission format, selecting one of the first and second transmission formats, applying to a modulator the digital information encoded according to the selected transmission format so as to generate a digitally modulated signal, transmitting the modulated signal, and receiving and decoding the digitally modulated signal according to any one of claims 1 to 5.

12. Apparatus for transmitting digital information characterised by encoding means (11, 12, 21, 23) to encode the digital information according to both a first transmission format and a second transmission format, a selector (24) for selecting one of the first and second transmission formats, a modulator (26) to modulate the digital information encoded according to the selected transmission format so as to generate a digitally modulated signal, a transmitter for transmitting the modulated signal, and a receiver according to any one of claims 6 to 10 for receiving and decoding the digitally modulated signal.
